# EUROPEAN PATENT SPECIFICATION

(11) **EP 0 936 679 B1**
(45) Date of publication and mention of the grant of the patent: **27.11.2002**
(21) Application number: 99103398.6
(22) Date of filing: 29.03.1995
(51) Int. Cl.: H01L 29/92, H01L 21/302, C23F 1/02

(54) **Method of manufacturing semiconductor devices having a built-in capacitor**
Verfahren zur Herstellung von Halbleitervorrichtungen mit eingebautem Kondensator
Procédé pour fabriquer des dispositifs semi-conducteurs avec condensateur intégré

(30) Priority: 30.03.1994 JP 6088394; 25.04.1994 JP 8668694
(43) Date of publication of application: 18.08.1999
(62) Divisional of application: 95104614.3
(73) Proprietor: MATSUSHITA ELECTRIC INDUSTRIAL CO., LTD., Kadoma-shi, Osaka (JP)
(72) Inventor: Matsumoto, Shoji, Toyama, 933-0014 (JP); Nagano, Yoshihisa, Suita-shi, Osaka 565 (JP); Shimada, Yasuhiro, Kyoto, 617-0002 (JP); Izutsu, Yasafumi, Nagaokakyo-shi, Kyoto-fu 617 (JP)
(74) Representative: Kügele, Bernhard

(56) References cited:
- EP-A- 0 295 581
- US-A- 5 094 712
- US-A- 5 397 433
- PATENT ABSTRACTS OF JAPAN vol. 013, no. 254 (E-772), 13 June 1989 & JP 01 053548 A (MATSUSHITA ELECTRIC IND CO LTD), 1 March 1989
- PATENT ABSTRACTS OF JAPAN vol. 012, no. 308 (E-647), 22 August 1988 & JP 63 076329 A (FUJITSU LTD), 6 April 1988
- PATENT ABSTRACTS OF JAPAN vol. 012, no. 106 (E-596), 6 April 1988 & JP 62 234331 A (HITACHI LTD;OTHERS: 01), 14 October 1987

## Description

### FIELD OF THE INVENTION

This invention relates to a method for manufacturing a semiconductor integrated circuit chip having a built-in capacitor in which high dielectric constant material or ferroelectric material is used as a capacitance insulation layer.

### BACKGROUND OF THE INVENTION

Recently, remarkable developments have occurred in the field of microcomputers having built-in capacitors of high dielectric constant materials. Such microcomputers contribute to reducing unnecessary radiation that causes electro-magnetic interference. Equally remarkable are developments in the field of ferroelectric non-volatile RAM which facilitates low-voltage operation and high read/write speed. The high dielectric constant materials or ferroelectric materials are made mainly of sintered metal oxide, and contain a substantial amount of very reactive oxygen. In forming a capacitor with such dielectric film, material for its electrodes must be least reactive; thus, precious metals such as platinum (Pt), palladium (Pd), etc. must be used.

In the prior art, platinum and palladium etching has been conducted by means of isotropic etching, such as wet etching with aqua regia or by ion milling with Ar gas. Because of the nature of isotropic etching, using wet etching with aqua regia and ion milling causes deteriorated processing accuracy. Furthermore, an additional problem with ion milling occurs because the etching speed on platinum, which is to form the electrode, and on silicon oxide, etc., which is underneath the platinum, are almost the same, the silicon oxide is also etched during ion milling.

In order to increase processing accuracy, research and development has been quite active in the precision processing technology with respect to the platinum layer and metal oxide dielectric thin film by means of a dry etching process, where Cl₂ and HBr are used as the etching gas (see, Extended Abstracts, Autumn Meeting 1991, The Japan Society of Applied Physics, 9P-ZF-17, p. 516; Extended Abstracts, Spring Meeting 1993, The Japan Society of Applied Physics, 30a-ZE-3, pp. 577).

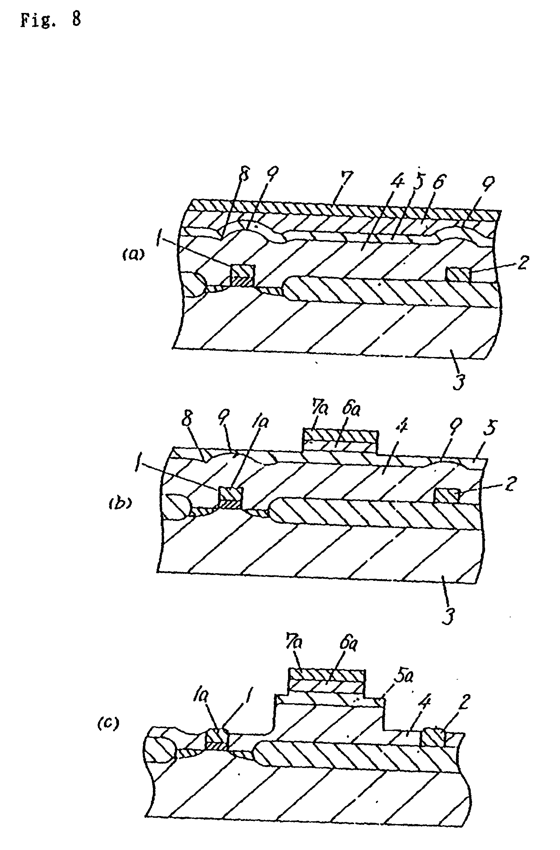

A conventional method for manufacturing semiconductor devices is described with reference to FIGs. 8(a)-(c). As shown in FIG. 8(a), a silicon oxide layer 4 is formed as an insulation layer on top of a circuit element 1 and a wiring 2 shaped on a silicon substrate 3. Over the silicon oxide layer 4 is a first platinum layer 5, a film of high dielectric constant material or ferroelectric material (hereinafter referred to as dielectric film) 6 and a second platinum layer 7.

The silicon oxide layer 4 reflects unevenness due to the circuit element 1 or wiring 2 already shaped on the silicon substrate 3 to have a hollow 8 or protrusion 9 on its surface, as shown in FIG. 8(a). Because dielectric film 6 is spin-coated on the uneven surface of silicon oxide layer 4, thickness of the dielectric film 6 is large at the hollow 8, and small at the protrusion 9.

Next, as shown in FIG. 8(b), top electrode 7a and capacitance insulation film 6a are formed by dry-etching the second platinum layer 7 and dielectric film 6 with Cl₂, HBr as the etching gas. The facility used for the etching is a magnetron reactive ion etching (RIE) mode dry etcher. Through the same etching procedure the first platinum layer 5 is etched to form a bottom electrode 5a; and a capacitor is thus formed. A layer to protect the capacitor, electrode wiring and protection layer for the electrode wiring are formed through process steps not shown in the figure; and a semiconductor device is completed.

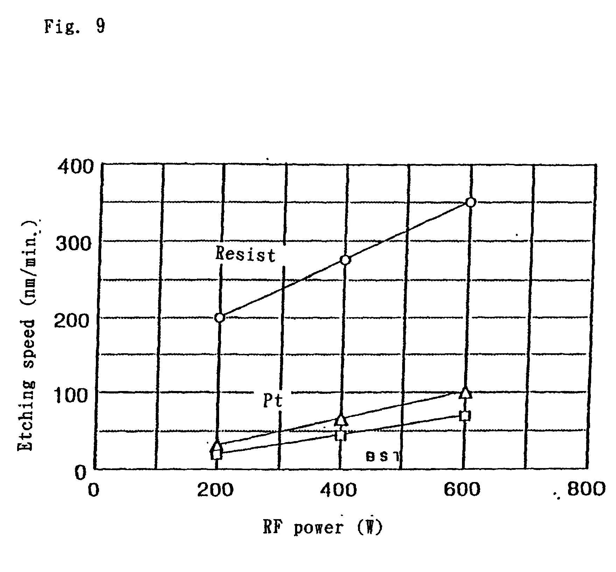

An example of the etching characteristics on platinum, high dielectric constant material (BaSrTiO₃, hereinafter referred to as BST) and resist is explained below when Cl₂ is used as the etching gas. FIG. 9 shows dependence of the etching speed of platinum, BST and resist to RF power. Where, the horizontal axis denotes RF power, the vertical axis denotes etching speeds of platinum, BST and resist.

The facility used for the etching is magnetron RIE mode dry etcher. The etcher conditions are: Cl₂ gas flow 20 sccm, gas pressure 1 Pa, RF power within a range between 200W and 600W, wafer temperature during etching below 20°C as its back surface is cooled with He.

FIG. 9 exhibits that platinum etching speed is increased from 30 nm/min. to 100 nm/min., BST etching speed is increased from 20 nm/min. to 70 nm/min. and resist etching speed is increased from 200 nm/min. to 350 nm/min., when RF power is raised from 200W to 600W.

When, the platinum/resist etching speed ratio increases from about 0.15 to about 0.29 along with the increase of RF power from 200W to 600W. The BST/resist etching speed ratio also increases from about 0.10 to about 0.20. Under any condition, the etching speed of resist is much faster than that of platinum and BST.

The time required to etch the platinum layer (200nm thick) and BST (200nm thick) with RF power at 600W is 4 min. 52 sec. The etching quantity of the resist during this time span is calculated from the resist etching speed to be 1703nm, a very large value. This means that, if the resist layer is thinner than 1700nm, the resist is entirely etched while etching is conducted on the platinum and BST. If this is to be prevented, a thick resist layer of more than about 3 µm thick has to be used.

As described above, however, when Cl₂ etching gas is used, the etching speed of resist is very high relative to that of platinum and BST. Consequently, while platinum and BST are being etched for a certain required thickness, the resist layer is also etched significantly. In order to prevent this from occurring a thick-layer resist needs to be used. But the thick-layer resist affects the definition level of the mask pattern at photolithography, rendering the formation of a fine pattern very difficult.

The etching speed of the silicon oxide layer is about 2.5 times faster than that of the platinum layer. So, as shown in FIG. 8(c), during formation of bottom electrode 5a, its underlayer, the silicon oxide layer 4 is significantly etched.

The problem with etching the silicon oxide layer 4 is illustrated in FIGs. 8(b) and 8(c). Before the thick part of first platinum layer 5 (located on the hollow 8 of silicon oxide layer 4) is completely etched off, the etching gas, which already etched the thin part of first platinum layer 5 (located on the extrusion 9 of silicon oxide layer 4), quickly attacks the underlying silicon oxide layer 4 to etch it off, and when gate electrode 1a of circuit element 1 and wiring 2 are exposed, they are also etched, rendering the transistor and other circuit element 1 inoperable.

In the case of ion milling where Ar gas is used as the etching gas, because the ratio of the etching speed of the second platinum layer 7 and dielectric film 6 to the etching speed of the silicon oxide layer 4 is low, when forming a capacitor in two separate etching process steps (e.g., etching on the second platinum layer 7 and dielectric film 6, and then on the first platinum layer 5), it is extremely difficult to stop the etching procedure so that the first platinum layer is not etched.

In the case of dry etching on platinum and ferroelectric material, because of its slow etching speed, the throughput of the production facility is poor.

It is further known to selectively etch Al using an etching gas which containschloroform, as described for example in the document EP-A-0 295 581 or JP-A-62 234 331.

### SUMMARY OF THE INVENTION

The objective of this invention is to offer a new method for manufacturing semiconductor devices having a built-in capacitor which is formed by slowing the etching speed on the resist, making the ratio of etching speed of platinum and dielectric material to resist large, and by selectively dry-etching the platinum and dielectric material at a fast etching speed.

This invention comprises process steps to form, on a substrate in which circuit elements and wirings, etc. are already shaped, an insulation layer, a first metal layer, a dielectric film and a second metal layer made of platinum, one after another, and then, form a top electrode and a capacitance film by dry etching the second metal layer and the dielectric film, and form a bottom electrode by dry etching the first metal layer; wherein, at least the etching gas for dry etching the second metal layer is a gas containing at least chloroform.

Silicon oxide layer may be employed as the insulation layer on the substrate, and a platinum layer or palladium layer as the first metal layer. Dry etching of the second metal layer and dielectric film may be conducted in a low pressure region not higher than about 5 Pa, where the etching speed is high.

Further, in this invention, an insulation layer, a first metal layer, a dielectric film and a second metal layer are formed on a substrate on which circuit elements and wirings, etc. are already shaped; and then a top electrode and a capacitance insulation layer are formed by dry etching the second metal layer and dielectric film in the low pressure region where the etching speed is high. When the first metal layer is exposed, the dielectric film left unetched on the first metal layer is removed under the high pressure region where the etching speed relative to the first metal layer is low, and then the mask pattern is applied, and the bottom electrode is formed by dry etching the first metal layer under the low pressure region where the etching speed is high.

The ratio of etching speed of the platinum and dielectric material to the resist can be increased by lowering the etching speed on the resist. Therefore, etching of the platinum and dielectric material may be conducted by using a mask of normal layer-thickness resist (generally speaking, about 1.2µm to about 2.0µm thick), instead of using a conventional thick-layer resist (about 3µm and thicker).

The invention itself, together with further objects and attendant advantages, will best be understood by reference to the following detailed description taken in conjunction with the accompanying drawings.

### BRIEF DESCRIPTION OF THE DRAWINGS

Figs. 1(a)-(d) are cross-sectional views showing the first half of process steps for manufacturing a capacitor.
Figs. 2(a)-(c) are cross-sectional views showing the second half of the process steps.
Fig. 3 is a characteristic chart showing the etching speed of the etching gas when etching gas is mixed HBr and O₂,
Fig. 4 is a characteristics chart showing the relationship between the etching speeds of platinum, BST and resist and the HF power, when chloroform is used as etching gas in accordance with this invention.
Fig. 5 is a characteristic chart showing the relationship between the etching speed of platinum and the pressure of etching gas.
Fig. 6 is a characteristic chart showing the relationship between the etching speed of dielectric material and the pressure of etching gas.
Fig. 7 is a characteristic chart showing the relationship between the intensity of the light emitted while the dielectric material is being etched and the pressure of etching gas.
Figs. 8(a)-(c) show cross-sectional views of a conventional method for manufacturing semiconductor devices.
Fig. 9 is a characteristics chart showing the relationship between the etching speeds of platinum, BST and resist and the HF power, when Cl₂ gas is used as the etching gas in a conventional manufacturing method.

### DESCRIPTION OF PREFERRED EMBODIMENTS

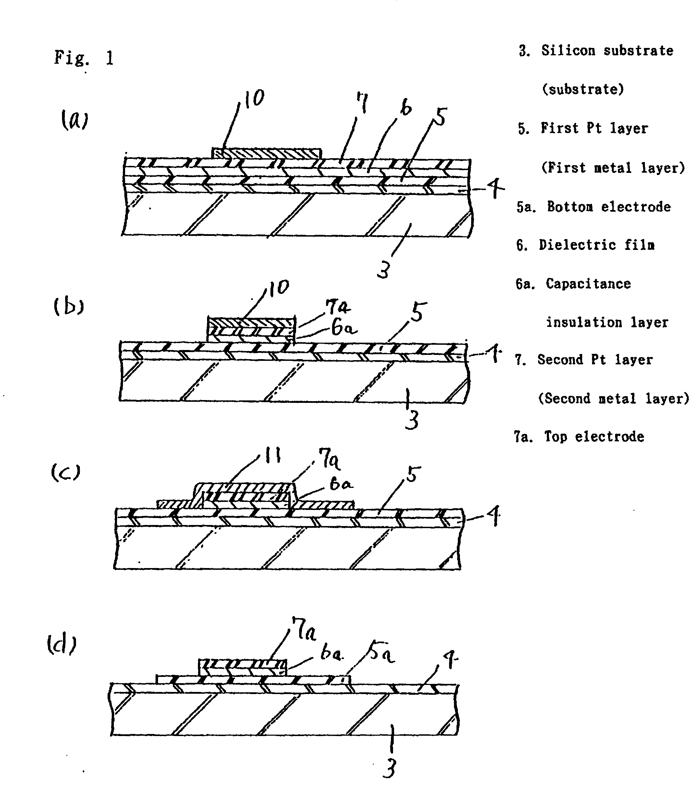

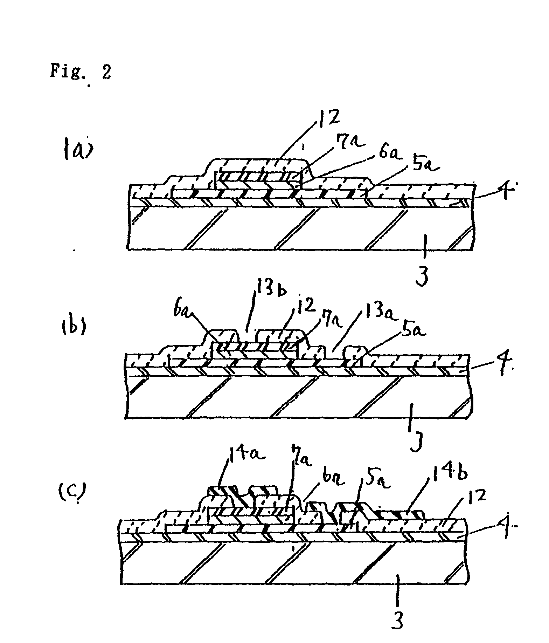

The invention is described below referring to Figs. 1(a)-(d) and Figs. 2(a)-(c), where the same constituent parts as the conventional parts shown in Fig. 8 are identified with the same numerals and their explanations are omitted, explaining only those elements that are different from the conventional method.

In Figs. 1(a)-(d) and Figs. 2(a)-(c), the circuit element 1 and wiring 2 as shown in FIG. 8 are omitted, and only the sector of a capacitor is described.

First, as shown in FIG. 1(a), an insulation layer 4 of silicon oxide, etc. is formed on the substrate 3 made of silicon, etc. On top of the insulation layer 4 is a first platinum layer 5 of about 200nm thickness. On top of the first platinum layer 5 is a dielectric film 6 having a high dielectric constant material or ferroelectric material of about 200nm thickness. Further on top of the dielectric film 6 is a second platinum layer 7 of about 200nm thickness. The dielectric film 6 is formed by means of the spin coating method. Then, top electrode 7a and a capacitance insulation film 6a are formed by dry etching the second platinum layer 7 and dielectric film 6, through a resist layer 10 applied on the second platinum layer 7. In this way, a device as shown in FIG. 1(b) is formed. Next, as shown in FIG. 1(c), the top electrode 7a, capacitance insulation film 6a and a part of the first platinum layer 5 are covered with a second resist layer 11 to etch the first platinum layer 5 with a mixed gas of HBr and O₂. Bottom electrode 5a is thus formed, as shown in FIG. 1(d).

As shown in FIG. 2(a), an interlayer insulation layer 12 is coated over the entire surface, contact holes 13a and 13b are provided above the bottom electrode 5a and top electrode 7a, respectively (Fig. 2(b)), and electrode wirings 14a and 14b, which connect to the top electrode 7a and bottom electrode 5a, respectively, via the contact holes 13b, 13a, are formed to complete a capacitor (FIG. 2(c)).

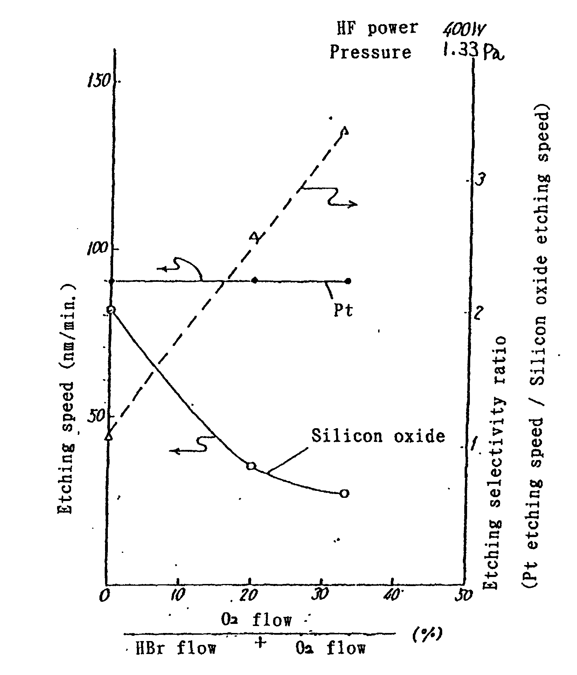

The use of a mixed gas of HBr and O₂ as the etching gas in dry etching the silicon oxide layer 4, the first platinum layer 5 and the second platinum layer 7, is explained below with reference to Fig. 3.

FIG. 3 shows the etching speeds of platinum and silicon oxide when HBr and O₂ mixed gas is used. The left vertical axis denotes the etching speeds of platinum and silicon oxide, the right vertical axis denotes the etching selectivity ratio (platinum etching speed/silicon oxide etching speed), and the horizontal axis indicates percentage of O₂ flow to the HBr and O₂ total etching gas flow. The etching facility used is a magnetron RIE mode dry etcher, with HF power 400W and pressure 1.33P during etching.

As indicated in FIG. 3, the etching speed on silicon oxide when HBr alone is used as the etching gas is about 80 nm/min., which is about half the speed when chloroform is used as the etching gas, or almost the same level as that on platinum (90 nm/min.). Namely, the platinum/silicon oxide etching selectivity ratio is improved to approximately 1.

When O₂ is mixed with HBr such that O₂ comprises about 30% of the total flow of etching gas, the speed of etching on silicon oxide decreases to about 1/3 as compared with the case of HBr alone; while the etching speed on platinum stays almost unchanged. This means that the platinum/silicon oxide etching selectivity ratio is improved to more than 3. In practical cases the process can be maintained stable when the ratio is 1.5 and up, therefore, the quantity of O₂ to the total etching gas flow may be chosen from the range of about 10%-35%.

In the case when platinum is dry etched using HBr and O₂ mixed gas, the silicon oxide reacts with Br and O₂ to compose a non-volatile compound which piles up on the silicon oxide layer 4 to protect the silicon oxide layer 4, lowering the etching speed. This makes it possible to selectively etch the first platinum layer 5. Namely, in completely etching off the first platinum layer 5, the silicon oxide layer 4 is never substantially etched as was the case in the conventional manufacturing method. Thus, possible damage to the circuit elements and wirings which are located underneath the silicon oxide layer 4 is avoided.

Although a platinum layer is used as the top electrode 7a and bottom electrode 5a in this embodiment, the sane effect is also obtained by the use of a less reactive metal, such as palladium.

Besides O₂ gas used in this embodiment as the gas to be mixed to HBr, a compound gas containing oxygen may also be used.

As described above, when a mixed gas of oxygen and hydrogen halide such as HBr is used as the etching gas for forming the bottom electrode 5a made of platinum, etc., only the first metal layer 5 made of platinum, etc. is selectively etched off, and etching on the silicon oxide layer 4 is suppressed; therefore the circuit elements and wiring, etc. underneath the silicon oxide layer are not damaged.

The method for manufacturing semiconductor devices of the invention, is the same as that shown in FIGs. 1(a)-(d) ,and FIGs. 2(a)-(c), except that chloroform is used as the etching gas on the platinum and dielectric material.

Dry etching on the platinum and dielectric material in the second embodiment using chloroform (CHCl₃) as the etching gas is explained below.

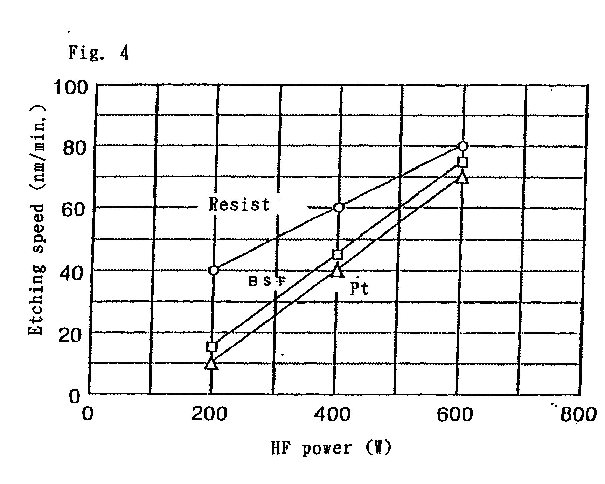

FIG. 4 shows the dependence of etching speeds of platinum, BST and resist to HF power when chloroform (CHCl₃) is used as the etching gas. In FIG. 4, the horizontal axis denotes HF power, and the vertical axis etching speeds of platinum, BST and resist. The etching facility used is a magnetron RIE mode dry etcher. The etching conditions are as follows: chloroform (CHCl₃) flow 20 sccm, gas pressure 1 Pa, and HF power within a range of about 200W-600W.

As FIG. 4 indicates, along with the elevation of HF power from about 200W to about 600W the speed of etching on platinum. increases from about 10 nm/min to about 70 nm/min, on BTS from about 15 nm/min to about 75 nm/min, and on resist from 40 nm/min to 80 nm/min. Platinum/resist etching speed ratio increases from about 0.25 to about 0.88 when HF power is raised from about 200W to about 600W. BST/resist etching speed ratio increase from about 0.38 to about 0.94.

The time needed to etch platinum (200nm thick layer) and BST (200nm thick film) is 5 min. 32 sec. at HF power load 600W. During that time frame, the resist is calculated to have been etched off by 443nm; which represents a remarkable improvement as compared with the conventional etching quantity 1703nm.

As explained above, by using chloroform (CHCl₃) as the etching gas to etch platinum and BST, the speed of etching on the resist is decreased, and the ratio of etching speed of platinum and BST to resist can be made larger. These changes in etching speed make it possible to conduct etching on platinum and BST using a normal layer thickness resist (generally speaking, thicknesses of about 1.2µm to about 2.0µm), instead of a conventionally used thick resist (about 3µm and thicker). Therefore, a fine pattern can be shaped with a high processing precision, without deteriorating the level of definition of a mask pattern.

When Cl₂ gas is used, carbon (C) and hydrogen (H), being the elements contained in the resist, react with Cl₂ gas to compose CCl₄, HCl, which are then separated and exhausted. The etching is considered to proceed this way, and the speed of etching on the resist increases.

On the other hand, when chloroform gas is used, the etching speed of the resist is decreased because of the carbon and hydrogen contained in the chloroform gas. It is believed that either the reaction with carbon and hydrogen in the resist is made less active, or a film of carbon and hydrogen is polymerized during etching which piles up on the resist while etching is going on, rendering the etching speed retarded.

In this example chloroform (CHCl₃) is used as the etching gas. However, according to the invention a gas which at least contains chloroform may be used to obtain the same results. A mixed gas of Cl₂ gas and chloroform, and a mixed gas of HBr and chloroform may be used.

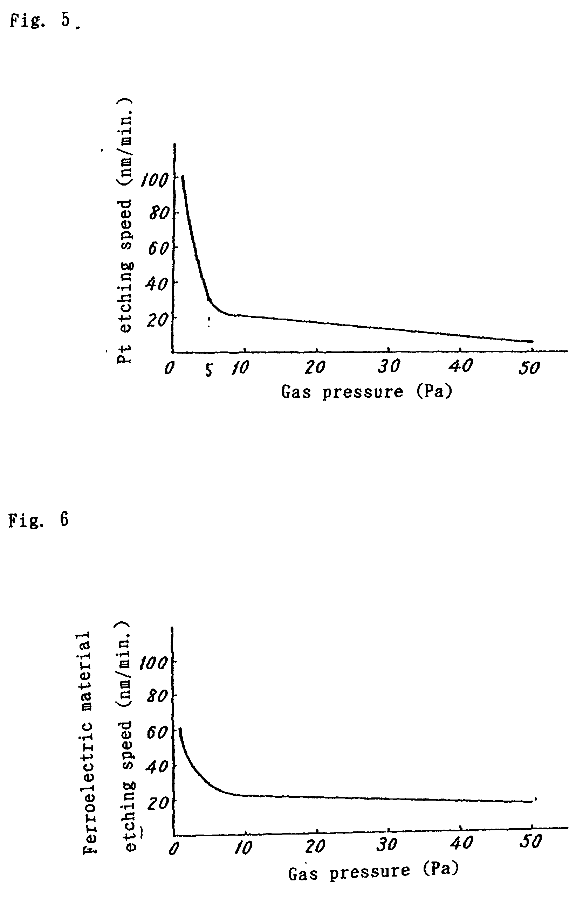

In FIG. 5, the horizontal axis denotes gas pressure and the vertical axis speed of etching on platinum. The etching facility used is a magnetron RIE mode dry etcher. The etching conditions are as follows: etching gas flow 20 sccm and HF power 600W. The substrate temperature during etching is below about 20°C because its back surface is cooled with helium (He).

As illustrated in FIG. 5, the speed of etching on platinum increases rapidly from about 30 nm/min to about 100 nm/min when the gas pressure decreases from about 5 Pa to about 1 Pa. Meanwhile, when the gas pressure is increased from about 5 Pa to about 50 Pa, the etching speed slows down from less than about 30 nm/min to about 5 nm/min.

The difference in the speed of etching on platinum due to different gas pressure regions is explained below.

In dry etching the platinum in the low pressure region (1-5 Pa), the physical spatter etching dominates, and the etching speed increases steeply along with the lowering pressure. In the high pressure region (5-50 Pa), the physical spatter etching is weak, and etching by the chemical reaction with platinum and etching gas seems to be proceeding, where the etching speed is very slow.

As explained in the foregoing description, the speed of etching on platinum during platinum etching can be increased steeply by conducting the etching in the low pressure region, about 1 Pa-5 Pa.

FIG. 6 shows the dependence of the etching speed of the dielectric material on the gas pressure when a mixed gas of Cl₂ gas and chloroform is used as etching gas. In FIG. 6, the horizontal axis denotes the gas pressure and the vertical axis denotes the etching speed on the dielectric material.

The dielectric material used as an example is BaSrTiO₃ (BST). The etching facility used is a magnetron RIE mode dry etcher. The etching conditions are as follows: etching gas flow 20 sccm and HF power 600W. The substrate temperature during etching is below 20°C because its back surface is cooled with He.

As FIG. 6 shows, the etching speed on the dielectric material increases from about 30 nm/min to about 60 nm/min along with the decreasing gas pressure from about 5 Pa to about 1 Pa. Meanwhile, when the gas pressure goes higher (from about 5 Pa to about 50 Pa), the etching speed gradually slows down (from about 30 nm/min to about 15 nm/min).

The difference in the etching speed on the dielectric material due to different gas pressure regions is explained below.

In dry etching the dielectric material in the low pressure region (1-5 Pa), the physical spatter etching dominates, and the etching speed increases steeply along with the lowering pressure. In the high pressure region (5-50 Pa), the physical spatter etching is weak, and etching by the chemical reaction with the dielectric material and etching gas occurs.

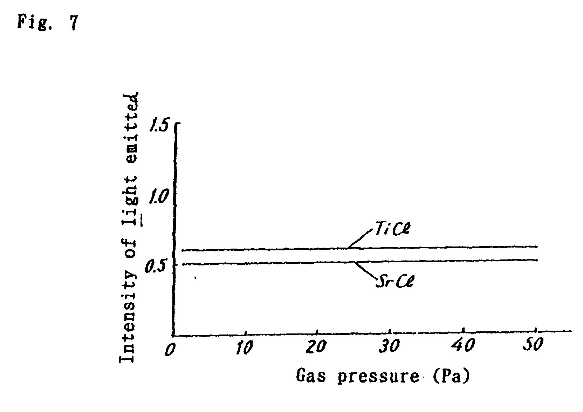

FIG. 7 shows the dependence of the intensity of light emitted during etching of the dielectric material to the gas pressure. The etching conditions remain the same as those in FIG. 6, and the horizontal axis denotes the gas pressure and vertical axis the intensity of light emitted.

During etching, light emission of 396.1 nm wavelength from SrCl and of 419.2 nm from TiCl were observed. The intensity of the light emission from the SrCl during etching stays constant at about 0.5, irrespective of the gas pressure; and that from TiCl also stays constant at about 0.6, irrespective of the gas pressure.

From the above, it is understood that in the high pressure region (5-50 Pa), where the etching speed is almost constant, etching on the dielectric material proceeds by chemical etching. It is also understood that in the low pressure region (1-5 Pa), where the etching speed increases steeply, when the intensity of light emitted is not different from that in the high pressure region (FIG. 7), the effect of physical spatter etching is added to the etching by chemical reaction. As a result, in the low pressure region, the etching speed is increased accordingly.

Based on the above, the etching speed can be increased by setting the etching conditions within the 1-5 Pa low pressure region. Thus, there is an improved production throughout.

When etching the dielectric material, the etching speed can be increased steeply by performing the etching in the 1-5 Pa low pressure region, and the etching by chemical reaction can be performed in the 5-50 Pa high pressure region.

The process steps of the method for manufacturing semiconductor devices according to another example are the same as those shown in FIG. 1. Therefore, the following explanation is directed to the conditions and means for the manufacturing method.

On the insulation layer 4 formed on a substrate of silicon, etc., the first platinum layer 5 of 200nm thickness is formed as a bottom electrode, on the first platinum layer 5 the dielectric film 6 is formed of 180 nm thickness, and then on the dielectric film 6 the second platinum layer 7 of 200 nm thickness is formed for a top electrode.

The first resist layer 10 is then applied on the second platinum layer 7 to etch down the second platinum layer 7 and the dielectric film 6. When the first platinum layer 5 is exposed, the etching is discontinued. The ratio of etching speed of the dielectric film 6 to the first platinum layer 5 underneath the film 6 needs to be high. Then, the second resist layer 11 is applied to etch off the first platinum layer 5, in order to form the bottom electrode 5a. In this step, the size of the first platinum layer 5 needs to be large enough to provide contacts through the interlayer insulation layer 12 at two points between the second platinum layer 7/the first platinum layer 5 and electrode wirings 14a/14b, which are located above the respective platinum layers.

For this purpose, in the process to etch down the second platinum layer 7 and dielectric film 6, first, the second platinum layer 7 must be etched in the low pressure region, where the speed of etching on platinum is high. The etching conditions in this process are: etching gas flow 20 sccm, gas pressure 1 Pa, HF power 600W and etching time 2 minutes. Next, start the etching of dielectric film 6 in the low pressure region, where the etching speed is high. The etching conditions should be: etching gas flow 20 sccm, gas pressure 1 Pa, HF power 600W and etching time 3 minutes. As soon as the first platinum layer 5 is exposed, shift the gas pressure to the high pressure region, in order that the remaining dielectric film 6 still on the surface of first platinum layer 5 is chemically etched off while maintaining the first platinum layer 5 unetched. The etching conditions at this process are: etching gas flow 20 sccm, gas pressure 50 Pa, HF power 600W and etching time 1 min.

In this example the ratio of etching speed of the dielectric material to platinum increases from about 0.6 to about 3, along with the increasing gas pressure from about 1 Pa to about 50 Pa.

As explained in the foregoing description, platinum and dielectric material can be selectively etched by shifting the pressure region of the etching gas.

As the next step, the first platinum layer 5 is etched in the low pressure region, where platinum etching speed is high. The etching conditions at this step are: etching gas flow 20 sccm, gas pressure 1 Pa, HF power 600W and etching time 2 minutes.

A mixed gas of Cl₂ gas and chloroform is used as an example of etching gas.

As described above, a desirable etching speed may be chosen to fit each platinum and dielectric material. Also a required ratio of the etching speed of platinum to dielectric material may be chosen by properly controlling the pressure region of the etching gas.

Through the process steps as explained by the foregoing description, a capacitor consisting of the second platinum layer 7 as top electrode, dielectric film 6 and the first platinum layer 5 as bottom electrode may be formed with high precision and without difficulty of manufacturing.

## Claims

1. A method of manufacturing a semiconductor device comprising the steps of:
forming an insulating layer (4), a first metal layer (5), a dielectric film (6), and a second metal layer (7) on a substrate (3) having circuit elements formed thereon, wherein said second metal layer (7) is a platinum layer;
dry etching said second metal layer (7) and said dielectric film (6) to form a top electrode (7a) and a capacitance insulation film (6a), wherein at least this dry etching step is performed using a gas which at least contains chloroform, and
dry etching said first metal layer (5) to form a bottom electrode (5a) after dry etching said second metal layer (7) and said dielectric layer (6).

2. A method of manufacturing a semiconductor device according to claim 1, wherein the gas containing chloroform consists of chloroform.

3. A method of manufacturing a semiconductor device according to claim 1, wherein the gas containing chloroform is a mixed gas of chloroform and Cl₂ gas.

4. A method of manufacturing a semiconductor device according to claim 1, wherein the gas containing chloroform is a mixed gas of chloroform and HBr.

5. A method of manufacturing a semiconductor device according to claim 1, wherein the insulation layer (4) is a silicon oxide.

6. A method of manufacturing a semiconductor device according to claim 1, wherein the first metal layer is comprised of platinum or palladium.

## Patentansprüche

1. Verfahren zur Herstellung einer Halbleiteranordnung mit den Schritten
Ausbildung einer Isolierschicht (4), einer ersten Metallschicht (5), einer dielektrischen Dünnschicht (6) und einer zweiten Metallschicht (7) auf einem Substrat (3) mit darauf ausgebildeten Schaltkreiselementen, wobei die zweite Metallschicht (7) eine Platinschicht ist;
Trockenätzen der zweiten Metallschicht (7) und der dielektrischen Dünnschicht (6) zur Ausbildung einer oberen Elektrode (7a) und einer kapazitiven Isolierschicht (6a), wobei zumindest dieser Trockenätz-Schritt mit einem Gas durchgeführt wird, das zumindest Chloroform enthält, und
Trockenätzen der ersten Metallschicht (5) zur Ausbildung einer unteren Elektrode (5a) nach dem Trockenätzen der zweiten Metallschicht (7) und der dielektrischen Dünnschicht (6).

2. Verfahren zur Herstellung einer Halbleiteranordnung nach Anspruch 1, **dadurch gekennzeichnet, dass** das chloroformhaltige Gas aus Chloroform besteht.

3. Verfahren zur Herstellung einer Halbleiteranordnung nach Anspruch 1, **dadurch gekennzeichnet, dass** das chloroformhaltige Gas ein Mischgas aus Chloroform und Cl₂-Gas ist.

4. Verfahren zur Herstellung einer Halbleiteranordnung nach Anspruch 1, **dadurch gekennzeichnet, dass** das chloroformhaltige Gas ein Mischgas aus Chloroform und HBr ist.

5. Verfahren zur Herstellung einer Halbleiteranordnung nach Anspruch 1, **dadurch gekennzeichnet, dass** die Isolierschicht (4) ein Siliciumoxid ist.

6. Verfahren zur Herstellung einer Halbleiteranordnung nach Anspruch 1, **dadurch gekennzeichnet, dass** die erste Metallschicht aus Platin oder Palladium besteht.

## Revendications

1. Procédé de fabrication d'un dispositif à semiconducteur comprenant les étapes consistant à :
former une couche isolante (4), une première couche de métal (5), un film diélectrique (6) et une seconde couche de métal (7) sur un substrat (3) comportant des éléments de circuit formés sur celui-ci, dans lequel ladite seconde couche de métal (7) est une couche de platine,
graver à sec ladite seconde couche de métal (7) et ledit film diélectrique (6) afin de former une électrode supérieure (7a) et un film d'isolement de capacité (6a), où au moins cette étape de gravure à sec est exécutée en utilisant un gaz qui contient au moins du chloroforme, et
graver à sec ladite première couche de métal (5) afin de former une électrode inférieure (5a) après gravure à sec de ladite seconde couche de métal (7) et de ladite couche diélectrique (6).

2. Procédé de fabrication d'un dispositif à semiconducteur selon la revendication 1, dans lequel le gaz contenant du chloroforme est constitué de chloroforme.

3. Procédé de fabrication d'un dispositif à semiconducteur selon la revendication 1, dans lequel le gaz contenant du chloroforme est un gaz mixte de chloroforme et de gaz Cl₂.

4. Procédé de fabrication d'un dispositif à semiconducteur selon la revendication 1, dans lequel le gaz contenant du chloroforme est un gaz mixte de chloroforme et de HBr.

5. Procédé de fabrication d'un dispositif à semiconducteur selon la revendication 1, dans lequel la couche d'isolement (4) est un oxyde de silicium.

6. Procédé de fabrication d'un dispositif à semiconducteur selon la revendication 1, dans lequel la première couche de métal est constituée de platine ou de palladium.
